# EUROPEAN PATENT APPLICATION

(11) **EP 4 527 616 A1**
(43) Date of publication of application: **26.03.2025**
(21) Application number: 23824124.4
(22) Date of filing: 26.05.2023
(51) Int. Cl.: B32B 15/08, B32B 3/30, B32B 15/20, B32B 7/12, H05K 3/28, H05K 1/09, H05K 3/46

(54) **COMPOSITE FILM, RIGID FLEXIBLE PRINTED CIRCUIT BOARD, AND ELECTRONIC DEVICE COMPRISING SAME**

(30) Priority: 17.06.2022 KR 20220074378; 24.08.2022 KR 20220106407
(71) Applicant: Samsung Electronics Co., Ltd., Suwon-si, Gyeonggi-do 16677 (KR)
(72) Inventor: KIM, Byeongkeol, Suwon-si Gyeonggi-do 16677 (KR); LEE, Youngsun, Suwon-si Gyeonggi-do 16677 (KR); HONG, Eunseok, Suwon-si Gyeonggi-do 16677 (KR)
(74) Representative: HGF
(86) International application number: PCT/KR2023/007291
(87) International publication number: WO 2023/243903

(57) **Abstract**

Disclosed are a composite film, a rigid flexible printed circuit board, and an electronic device comprising same. The present invention relates to a composite film, a rigid flexible printed circuit board using same, and an electronic device. According to an embodiment, the composite film comprises: a base film layer; a first metal thin film layer formed on one surface of the base film layer; and a second metal thin film layer formed on the opposite surface, wherein the first metal thin film layer and the second metal thin film layer include a soft etching treatment area and an oxide surface treatment area, and the surface roughness of the soft etching treatment area and the oxide surface treatment area are different from each other. Various other embodiments are possible.

## Description

### TECHNICAL FIELD

Embodiments of the present disclosure relate to a composite film, a rigid flexible printed circuit board, and an electronic device including the same.

### BACKGROUND ART

Generally, an electronic device refers to a device that performs a specific function according to a loaded program, such as a home appliance, an electronic note, a portable multimedia player, a mobile communication terminal, a tablet personal computer (PC), a video/audio device, a desktop/laptop computer, a vehicle navigation system, and the like. For example, such electronic devices may output stored information as sound or images. As electronic devices have become highly integrated and high-speed and high-volume wireless communication has come into wider use, various functions have been mounted in a single electronic device such as a mobile communication terminal. For example, an entertainment function such as gaming, a multimedia function such as music/video play, a communication and security function for mobile banking, a scheduling function, and an electronic wallet function as well as a communication function have been integrated in a single electronic device.

Among the electronic devices, a display device provides a user with information by displaying various images on a display screen. The display device generally displays information within an allocated screen. Flexible display devices that include flexible display panels that may be folded, bent, or rolled are being developed. The flexible display devices, unlike rigid display devices, may be folded, rolled, or bent. The flexible display devices that may be changed in various shapes may be carried without being restricted by an existing screen size, which may improve user convenience.

### DISCLOSURE OF THE INVENTION

### TECHNICAL SOLUTIONS

An electronic device may include a rigid flexible printed circuit board (RFPCB) that electrically connects components (e.g., parts or circuits).

For the RFPCB with repeated bending life in a hinge portion of a flexible electronic device, an oxide surface treatment is applied uniformly (e.g., on the entire surface) to an inner copper layer surface for adhesion and to prevent delamination. The oxide surface treatment may reinforce adhesion with components (e.g., a prepreg (PPG) and a laser via in a rigid area, or a coverlay in a flexible area) of the RFPCB, however, it may cause a decrease in the bending life, cracks in a notch of the surface roughness during the repeated bending, and product defects. This frequently occurs in a hinge portion of a foldable electronic device (e.g., a foldable smartphone) having a structure in which repeated bending occurs, and improvement of the repeated bending life of the hinge portion is required.

According to various embodiments, there is provided a composite film capable of improving adhesion, bending life, and bendability through a heterogeneous surface treatment of a metal film.

According to various embodiments, there is provided an RFPCB with improved adhesion between components, and improved bending life and bendability, by applying a composite film having a metal film subjected to a heterogeneous surface treatment.

According to various embodiments, there is provided an electronic device with improved bending life and bendability of a hinge portion having a repeated bending structure.

The technical goals to be achieved are not limited to those described above, and other technical goals not mentioned above will be clearly understood by one of ordinary skill in the art from the following description.

According to an embodiment, a composite film includes a base film layer; a first metal thin film layer formed on one surface of the base film layer; and a second metal thin film layer formed on an opposite surface. The first metal thin film layer and the second metal thin film layer may include a soft etching-treated area and an oxide surface-treated area, and the soft etching-treated area and the oxide surface-treated area may have different surface roughness.

According to an embodiment, an RFPCB includes a composite film; a flexible area formed on at least a portion of at least one surface of the composite film; and a rigid area formed on at least a portion of the at least one surface of the composite film. The composite film may include a base film layer; and a first metal thin film layer formed on one surface of the base film layer; and a second metal thin film layer formed on an opposite surface, the first metal thin film layer and the second metal thin film layer may include a soft etching-treated area and an oxide surface-treated area, and the soft etching-treated area and the oxide surface-treated area may have different surface roughness.

According to an embodiment, an electronic device includes a flexible display; and the composite film of or the RFPCB.

### EFFECTS OF THE INVENTION

According to an embodiment, a composite film applicable to an electronic device (e.g., a television (TV), a smartphone, a watch, a tablet personal computer (PC)) including a flexible display and capable of improving the bending life and bendability when applied to a hinge portion of an electronic device where repeated bending occurs, and a rigid flexible printed circuit board (RFPCB) to which the composite film is applied may be provided.

The effects to be achieved are not limited to those described above, and other effects not mentioned above will be clearly understood by one of ordinary skill in the art from the following description.

### BRIEF DESCRIPTION OF DRAWINGS

FIG. 1 is a block diagram illustrating an electronic device in a network environment according to various embodiments.
FIG. 2 is a view of an electronic device in an unfolded state according to various embodiments.
FIG. 3 is a view of an electronic device in a folded state according to various embodiments.
FIGS. 4A and 4B are perspective views illustrating an example of a fully unfolded state and a partially unfolded state (or an intermediate state) of an electronic device according to various embodiments.
FIG. 5 is a cross-sectional view illustrating a configuration of a composite film according to various embodiments.
FIG. 6 is a cross-sectional view illustrating a configuration of a rigid flexible printed circuit board (RFPCB) including a composite film according to various embodiments.
FIG. 7A is a perspective view illustrating a state where an RFPCB is disposed between a hinge housing and a hinge assembly of a foldable electronic device according to various embodiments.
FIG. 7B is a cross-sectional view schematically illustrating a state where an RFPCB is disposed between a hinge housing and a hinge assembly of a foldable electronic device according to various embodiments.
FIG. 8 is a flowchart of an operation of manufacturing a composite film according to various embodiments.
FIG. 9 is a flowchart of an operation of manufacturing an RFPCB according to various embodiments.

### BEST MODE FOR CARRYING OUT THE INVENTION

Hereinafter, embodiments will be described in detail with reference to the accompanying drawings. When describing the embodiments with reference to the accompanying drawings, like reference numerals refer to like elements and a repeated description related thereto will be omitted.

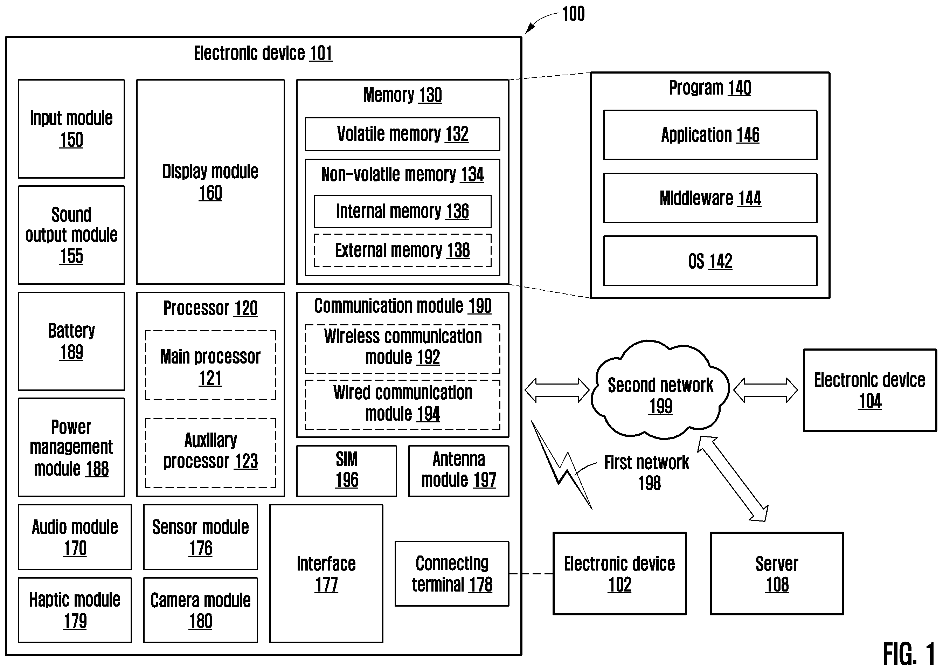

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or communicate with an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, and a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the above components may be omitted from the electronic device 101, or one or more other components may be added in the electronic device 101. In some embodiments, some of the components (e.g., the sensor module 176, the camera module 180, or the antenna module 197) may be integrated as a single component (e.g., the display module 160).

The processor 120 may execute, for example, software (e.g., a program 140) to control at least one other component (e.g., a hardware or software component) of the electronic device 101 connected to the processor 120, and may perform various data processing or computation. According to an embodiment, as at least a portion of data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently of, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for artificial intelligence model processing. An artificial intelligence model may be generated through machine learning. Such learning may be performed by, for example, the electronic device 101 in which artificial intelligence is performed, or performed via a separate server (e.g., the server 108). Learning algorithms may include, but are not limited to, for example, supervised learning, unsupervised learning, semi-supervised learning, or reinforcement learning. The artificial intelligence model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), and a bidirectional recurrent deep neural network (BRDNN), a deep Q-network, or a combination of two or more thereof, but is not limited thereto. The artificial intelligence model may additionally or alternatively include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored as software in the memory 130, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output a sound signal to the outside the electronic device 101. The sound output module 155 may include, for example, a speaker or a receiver. The speaker may be used for general purposes, such as playing multimedia or playing record. The receiver may be used to receive an incoming call. According to an embodiment, the receiver may be implemented separately from the speaker or as a portion of the speaker.

The display module 160 may visually provide information to the outside (e.g., a user) of the electronic device 101. The display module 160 may include, for example, a display, a hologram device, or a projector and control circuitry to control a corresponding one of the display, the hologram device, and the projector. According to an embodiment, the display module 160 may include a touch sensor adapted to sense a touch, or a pressure sensor adapted to measure an intensity of a force incurred by the touch.

The audio module 170 may convert a sound into an electric signal or vice versa. According to an embodiment, the audio module 170 may obtain the sound via the input module 150 or output the sound via the sound output module 155 or an external electronic device (e.g., an electronic device 102 such as a speaker or a headphone) directly or wirelessly connected to the electronic device 101.

The sensor module 176 may detect an operational state (e.g., power or temperature) of the electronic device 101 or an environmental state (e.g., a state of a user) external to the electronic device 101, and generate an electric signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electric signal into a mechanical stimulus (e.g., a vibration or a movement) or an electrical stimulus which may be recognized by a user via his or her tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more CPs that are operable independently of the processor 120 (e.g., an AP) and that support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local region network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., a LAN or a wide area network (WAN))). These various types of communication modules may be implemented as a single component (e.g., a single chip), or may be implemented as multi components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), an array antenna, analog beam-forming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or the power may be transmitted or received between the communication module 190 and the external electronic device via the at least one selected antenna. According to an embodiment, another component (e.g., a radio frequency integrated circuit (RFIC)) other than the radiating element may be additionally formed as a portion of the antenna module 197.

According to an embodiment, the antenna module 197 may form a mmWave antenna module. According to an embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of the same type as or a different type from the electronic device 101. According to an embodiment, all or some of operations to be executed by the electronic device 101 may be executed at one or more external electronic devices (e.g., the external devices 102 and 104, and the server 108). For example, if the electronic device 101 needs to perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and may transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

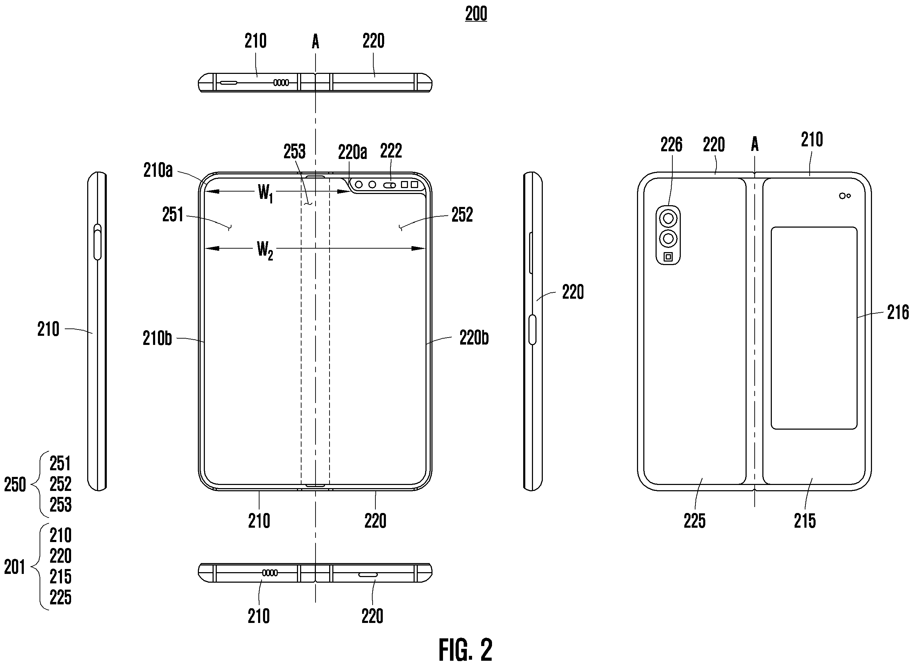

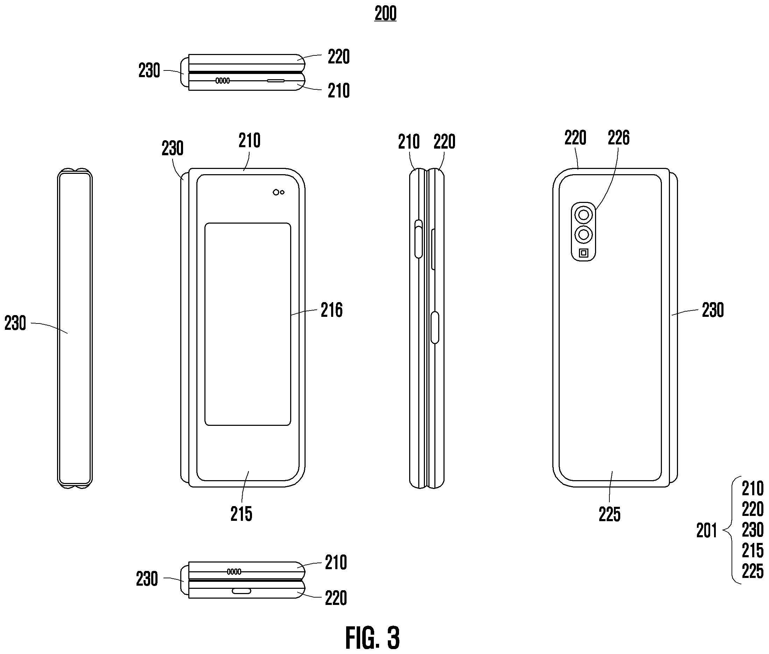

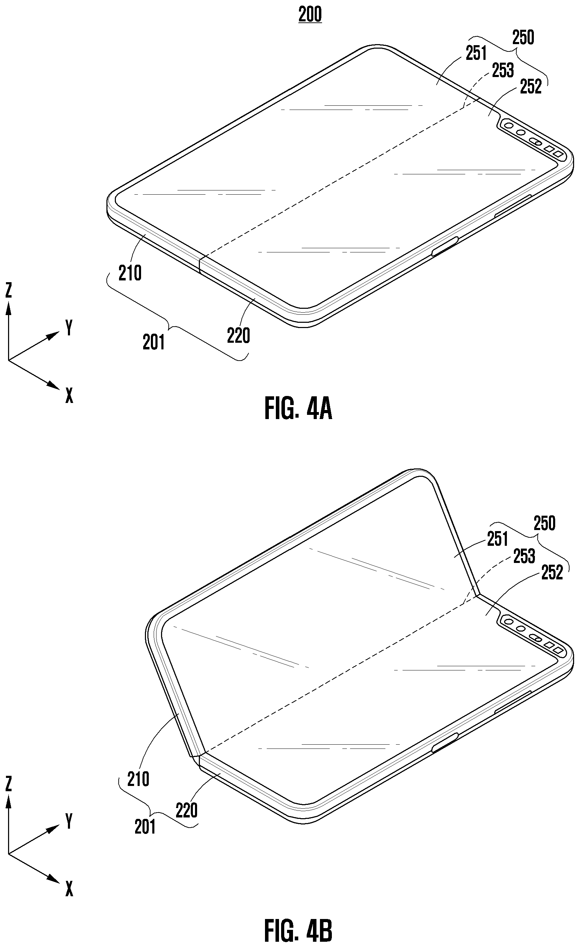

FIG. 2 is a view of an electronic device 200 in an unfolded state according to various embodiments. FIG. 3 is a view of the electronic device 200 in a folded state according to various embodiments. FIGS. 4A and 4B are perspective views illustrating an example of a fully unfolded state and a partially unfolded state (or an intermediate state) of the electronic device 200 according to various embodiments.

The electronic device 200 of FIGS. 2 to 4A may be an example of the electronic device 101 shown in FIG. 1, and may be a foldable or bendable electronic device.

In FIGS. 4A and 4B, illustrated is a spatial coordinate system defined by the X-axis, the Y-axis, and the Z-axis that are orthogonal to each other. Here, the X-axis may represent a width direction of the electronic device, the Y-axis may represent a length direction of the electronic device, and the Z-axis may represent a height (or thickness) direction of the electronic device. In the following description, a "first direction" may refer to a direction parallel to the Z-axis.

Referring to FIGS. 2 and 3, in an embodiment, the electronic device 200 may include a foldable housing 201, and a flexible or foldable display 250 (hereinafter simply referred to as the "display" 250) (e.g., the display device 160 of FIG. 1) disposed in a space formed by the foldable housing 201. According to an embodiment, a surface on which the display 250 is disposed (or a surface on which the display 250 is viewed from the outside of the electronic device 200) may be defined as a front surface of the electronic device 200. In addition, a surface opposite to the front surface may be defined as a rear surface of the electronic device 200. Further, a surface surrounding a space between the front surface and the rear surface may be defined as a side surface of the electronic device 200.

According to an embodiment, the foldable housing 201 may include a first housing structure 210, a second housing structure 220 including a sensor area 222, a first rear cover 215, a second rear cover 225, and a hinge structure 230. Here, the hinge structure 230 may include a hinge cover that covers a foldable portion of the foldable housing 201. The foldable housing 201 of the electronic device 200 is not limited to the shape and combination shown in FIGS. 2 and 3, and may be implemented in a different shape or a different combination of components. For example, in another embodiment, the first housing structure 210 and the first rear cover 215 may be integrally formed, and the second housing structure 220 and the second rear cover 225 may be integrally formed.

According to various embodiments, the first housing structure 210 may be connected to the hinge structure 230, and may include a first surface facing a first direction, and a second surface facing a second direction opposite to the first direction. The second housing structure 220 may be connected to the hinge structure 230 and may include a third surface facing a third direction and a fourth surface facing a fourth direction opposite to the third direction. The second housing structure 220 may rotate with respect to the first housing structure 210 about the hinge structure 230. A state of the electronic device 200 may be changed to a folded state or an unfolded state.

According to an embodiment, the first surface may face the third surface in a state in which the electronic device 200 is fully folded, and the third direction may be identical to the first direction in a state in which the electronic device 200 is fully unfolded.

According to various embodiments, the first housing structure 210 and the second housing structure 220 are disposed on both sides with respect to a folding axis A and generally may be symmetrical with respect to the folding axis A. As to be described hereinafter, an angle or distance between the first housing structure 210 and the second housing structure 220 may vary depending on whether the electronic device 200 is in the unfolded state, the folded state, or an intermediate state (e.g., a partially folded state or a partially unfolded state). According to an embodiment, unlike the first housing structure 210, the second housing structure 220 may additionally include the sensor area 222, in which various sensors are arranged. However, the first housing structure 210 and the second housing structure 220 may be mutually symmetrical in areas other than the sensor area 222. In another embodiment, the sensor area 222 may be additionally disposed in or replaced with at least a partial area of the second housing structure 220. The sensor area 222 may include, for example, a camera hole area, a sensor hole area, an under-display camera (UDC) area, and/or an under-display sensor (UDS) area.

According to various embodiments, as shown in FIG. 2, the first housing structure 210 and the second housing structure 220 may together form a recess for accommodating the display 250. In an embodiment, due to the sensor area 222, the recess may have at least two different widths in a direction perpendicular to the folding axis A. For example, the recess may have a first width W₁ between a first portion 210a of the first housing structure 210 parallel to the folding axis A and a first portion 220a of the second housing structure 220 formed on a periphery of the sensor area 222, and a second width W₂ formed by a second portion 210b of the first housing structure 210 and a second portion 220b of the second housing structure 220 not corresponding to the sensor area 222 and being parallel to the folding axis A. In this example, the second width W₂ may be greater than the first width W₁. In an embodiment, the first portion 220a and the second portion 220b of the second housing structure 220 may be at different distances from the folding axis A. The widths of the recess are not limited to the shown example. In another embodiment, the recess may have a plurality of widths due to the shape of the sensor area 222 or asymmetrical portions of the first housing structure 210 and the second housing structure 220. According to various embodiments, the sensor area 222 may be formed to have a predetermined area adjacent to one corner of the second housing structure 220. However, the arrangement, shape, and size of the sensor area 222 are not limited to the shown example. For example, in another embodiment, the sensor area 222 may be provided at another corner of the second housing structure 220 or in a predetermined area between an upper corner and a lower corner. In an embodiment, components embedded in the electronic device 200 to perform various functions may be exposed to the front surface of the electronic device 200 through the sensor area 222 or through one or more openings provided in the sensor area 222. In various embodiments, the components may include various types of sensors. The sensors may include, for example, at least one of a front camera, a receiver, or a proximity sensor. According to various embodiments, the sensor area 222 may not be included in the second housing structure 220 or may be formed at a position different from that shown in the drawings.

According to various embodiments, at least a portion of the first housing structure 210 and the second housing structure 220 may be formed of a metal material or a non-metal material having a selected magnitude of rigidity to support the display 250. At least a portion formed of the metal material may provide a ground plane for the electronic device 200, and may be electrically connected to a ground line formed on a printed circuit board (PCB) disposed inside the foldable housing 201.

According to various embodiments, the first rear cover 215 may be disposed on one side of the folding axis A on the rear surface of the electronic device 200, and may have, for example, a substantially rectangular periphery that may be enclosed by the first housing structure 210. Similarly, the second rear cover 225 may be disposed on the other side of the folding axis A on the rear surface of the electronic device 200, and may have a periphery that may be enclosed by the second housing structure 220.

According to various embodiments, the first rear cover 215 and the second rear cover 225 may be substantially symmetrical with respect to the folding axis A. However, the first rear cover 215 and the second rear cover 225 are not necessarily mutually symmetrical, and in another embodiment, the electronic device 200 may include a first rear cover 215 and a second rear cover 225 in various shapes. In another embodiment, the first rear cover 215 may be formed integrally with the first housing structure 210, and the second rear cover 225 may be formed integrally with the second housing structure 220.

According to various embodiments, the first rear cover 215, the second rear cover 225, the first housing structure 210, and the second housing structure 220 may form a space in which various components (e.g., a PCB, an antenna module, a sensor module, or a battery) of the electronic device 200 are to be arranged. In an embodiment, one or more components may be disposed or visually exposed on the rear surface of the electronic device 200. For example, at least a portion of a sub-display may be visually exposed through a first rear area 216 of the first rear cover 215. In another embodiment, one or more components or sensors may be visually exposed through a second rear area 226 of the second rear cover 225. In various embodiments, the sensors may include a proximity sensor and/or a rear camera module.

According to various embodiments, a front camera exposed to the front surface of the electronic device 200 through one or more openings provided in the sensor area 222, or a rear camera exposed through the second rear area 226 of the second rear cover 225 may include one or more lenses, an image sensor, and/or an ISP. A flash may include, for example, a light emitting diode (LED) or a xenon lamp. In some embodiments, two or more lenses (e.g., infrared camera, wide-angle, and telephoto lenses) and image sensors may be disposed on one surface of the electronic device 200.

Referring to FIG. 3, the hinge cover may be disposed between the first housing structure 210 and the second housing structure 220 to cover internal components (e.g., the hinge structure 230). According to an embodiment, the hinge structure 230 may be covered by a portion of the first housing structure 210 and a portion of the second housing structure 220, or may be exposed to the outside, depending on the state (e.g., the unfolded state, the intermediate state, or the folded state) of the electronic device 200.

According to an embodiment, when the electronic device 200 is in the unfolded state (e.g., the fully unfolded state) as illustrated in FIG. 2, the hinge structure 230 may be covered by the first housing structure 210 and the second housing structure 220 not to be exposed. In another example, when the electronic device 200 is in the folded state (e.g., the fully folded state) as illustrated in FIG. 3, the hinge structure 230 may be exposed to the outside, being between the first housing structure 210 and the second housing structure 220. In another example, when the first housing structure 210 and the second housing structure 220 are in the intermediate state where the first housing structure 210 and the second housing structure 220 are folded with a certain angle, a portion of the hinge structure 230 may be exposed to the outside between the first housing structure 210 and the second housing structure 220. In this example, an exposed area may be less than an area exposed in the fully folded state. In an embodiment, the hinge cover 230 may have a curved surface.

According to various embodiments, the display 250 may be disposed in a space formed by the foldable housing 201. For example, the display 250 may be seated on the recess formed by the foldable housing 201 and may be viewed from the outside through the front surface of the electronic device 200. For example, the display 250 may constitute most of the front surface of the electronic device 200. Accordingly, the front surface of the electronic device 200 may include the display 250, and a partial area of the first housing structure 210 and a partial area of the second housing structure 220, which are adjacent to the display 250. In addition, the rear surface of the electronic device 200 may include the first rear cover 215, a partial area of the first housing structure 210 adjacent to the first rear cover 215, the second rear cover 225, and a partial area of the second housing structure 220 adjacent to the second rear cover 225.

According to various embodiments, the display 250 may refer to a display having at least a partial area that is deformable into a flat surface or a curved surface. In an embodiment, the display 250 may include a folding area 253, a first area 251 disposed on one side of the folding area 253 (e.g., on the left side of the folding area 253 shown in FIG. 2), and a second area 252 disposed on the other side of the folding area 253 (e.g., on the right side of the folding area 253 shown in FIG. 2).

However, such an area division of the display 250 shown in FIG. 2 is merely an example, and the display 250 may be divided into a plurality of areas (e.g., four or more areas, or two areas) depending on a structure or functions thereof. For example, in an embodiment shown in FIG. 2, the display 250 may be divided into areas based on the folding area 253 extending in parallel to the folding axis A. In another embodiment, the display 250 may be divided into areas based on another folding axis (e.g., a folding axis parallel to a width direction of an electronic device).

According to various embodiments, the display 250 may be coupled to or disposed adjacent to a touch panel including a touch sensing circuit and a pressure sensor for measuring a strength (a pressure) of a touch. For example, the display 250 may be coupled to or disposed adjacent to a touch panel for detecting a stylus pen of an electromagnetic resonance (EMR) type, as an example of the touch panel.

According to various embodiments, the first area 251 and the second area 252 may have globally symmetrical shapes around the folding area 253. However, unlike the first area 251, the second area 252 may include a notch that is cut according to the presence of the sensor area 222, but may be symmetrical to the first area 251 in the other areas. In other words, the first area 251 and the second area 252 may include mutually symmetrical portions and mutually asymmetrical portions.

According to various embodiments, an edge thickness of each of the first area 251 and the second area 252 may be different from an edge thickness of the folding area 253. The edge thickness of the folding area 253 may be less than those of the first area 251 and the second area 252. For example, the first area 251 and the second area 252 may be asymmetrical in terms of the thickness when viewed in a cross section of the first area 251 and the second area 252. For example, an edge of the first area 251 may be formed to have a first radius of curvature, and an edge of the second area 252 may be formed to have a second radius of curvature different from the first radius of curvature. In another embodiment, the first area 251 and the second area 252 may be symmetrical in terms of the thickness when viewed in the cross section of the first area 251 and the second area 252.

Hereinafter, each area of the display 250, and operations of the first housing structure 210 and the second housing structure 220 depending on the state (e.g., the folded state, the unfolded state, or the intermediate state) of the electronic device 200 will be described.

According to various embodiments, when the electronic device 200 is in the unfolded state (e.g., FIG. 2), the first housing structure 210 and the second housing structure 220 may be arranged to face substantially the same direction while forming an angle of 180 degrees. The surface of the first area 251 of the display 250 and the surface of the second area 252 thereof may face the same direction (e.g., a front direction of an electronic device) while forming 180 degrees. The folding area 253 may form substantially the same plane in conjunction with the first area 251 and the second area 252. In another embodiment, when the electronic device 200 is in the flat state, the first housing structure 210 and the second housing structure 220 may be folded opposite while rotating by a predetermined angle (e.g., about 360 degrees) with respect to each other such that the first rear cover 215 and the second rear cover 225 face each other. In other words, the first area 251 and the second area 252 of the display may be disposed to face in opposite directions with respect to each other.

According to various embodiments, when the electronic device 200 is in the folded state (e.g., FIG. 3), the first housing structure 210 and the second housing structure 220 may be arranged to face each other. The surface of the first area 251 and the surface of the second area 252 of the display 250 may face each other while forming a narrow angle (e.g., an angle between about 0 degrees to about 10 degrees). For example, at least a portion of the folding area 253 may form a curved surface having a predetermined curvature.

According to various embodiments, when the electronic device 200 is in the intermediate state, the first housing structure 210 and the second housing structure 220 may be arranged to form a certain angle (e.g., about 90 degrees) therebetween. The surface of the first area 251 and the surface of the second area 252 of the display 250 may form an angle greater than that in the folded state and smaller than that in the unfolded state. At least a portion of the folding area 253 may include a curved surface having a predetermined curvature, and the curvature may be less than that in the folded state.

FIG. 4A illustrates a fully unfolded state of the electronic device 200, and FIG. 4B illustrates an intermediate state in which the electronic device 200 is partially unfolded. As described above, the state of the electronic device 200 may be changed to the folded state or the unfolded state. According to an embodiment, when viewed in a direction of a folding axis (e.g., the axis A of FIG. 2), the electronic device 200 may be folded in two types, i.e., an "in-folding" type in which the front surface of the electronic device 200 is folded to form an acute angle, and an "out-folding" type in which the front surface of the electronic device 200 is folded to form an obtuse angle. In an example, in the state in which the electronic device 200 is folded in the in-folding type, the first surface of the first housing structure 210 may face the third surface of the second housing structure 220. In the fully unfolded state, the first surface of the first housing structure 210 and the third surface of the second housing structure 220 may face the same direction (e.g., a direction parallel to the z-axis).

In another example, when the electronic device 200 is folded in the out-folding type, the second surface of the first housing structure 210 may face the fourth surface of the second housing structure 220.

In addition, although not shown in the drawings, the electronic device 200 may include a plurality of hinge axes (e.g., two parallel hinge axes including the axis A of FIG. 2 and another axis parallel to the axis A). In this example, the electronic device 200 may also be folded in a "multi-folding" type in which the in-folding type and the out-folding type are combined. In addition, although not shown, the hinge axis may be formed longitudinally or transversely when the electronic device 200 is viewed from the top. In an example, all the plurality of hinge axes may be arranged in the same direction. In another example, some of the plurality of hinge axes may be arranged in different directions and folded.

The in-folding type may refer to a state in which the display 250 is not exposed to the outside in the fully folded state. The out-folding type may refer to a state in which the display 250 is exposed to the outside in the fully folded state. FIG. 4B illustrates the intermediate state in which the electronic device 200 is partially unfolded in an in-folding process.

Although the state in which the electronic device 200 is folded in the in-folding type will be described below for convenience's sake, it should be noted that the description may be similarly applied in the state in which the electronic device 200 is folded in the out-folding type.

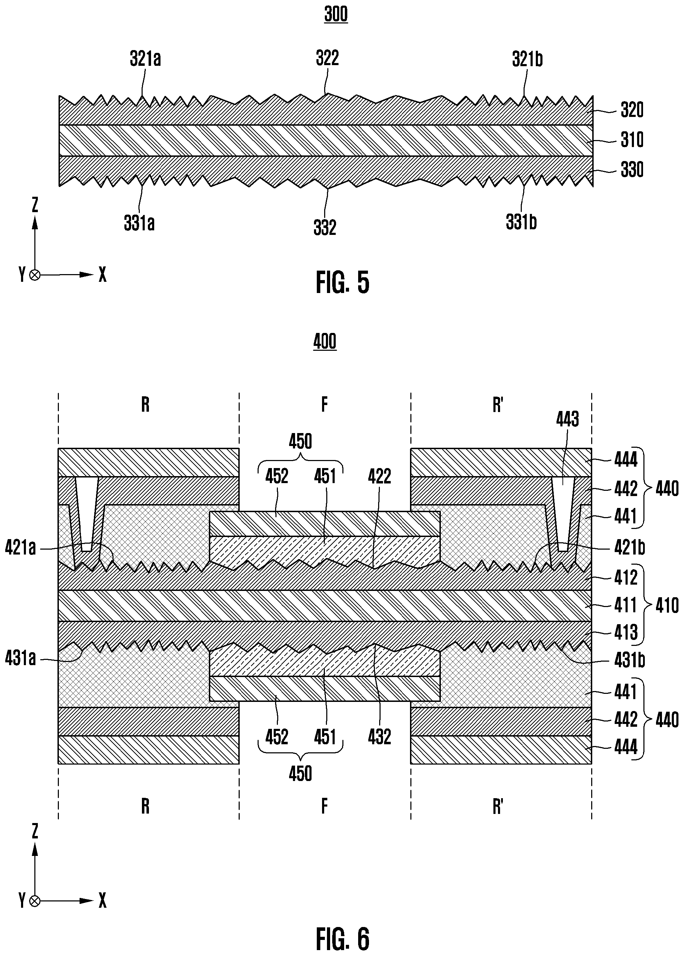

FIG. 5 is a cross-sectional view of a composite film according to various embodiments, and FIG. 5 is a cross-sectional view of a composite film 300 to be applied to a composite film layer 410 of a rigid flexible printed circuit board (RFPCB) 400 of FIG. 6.

Referring to FIG. 5, according to various embodiments, the composite film 300 may include a base film layer 310, and metal thin film layers 320 and 330 on both surfaces of the base film layer 310.

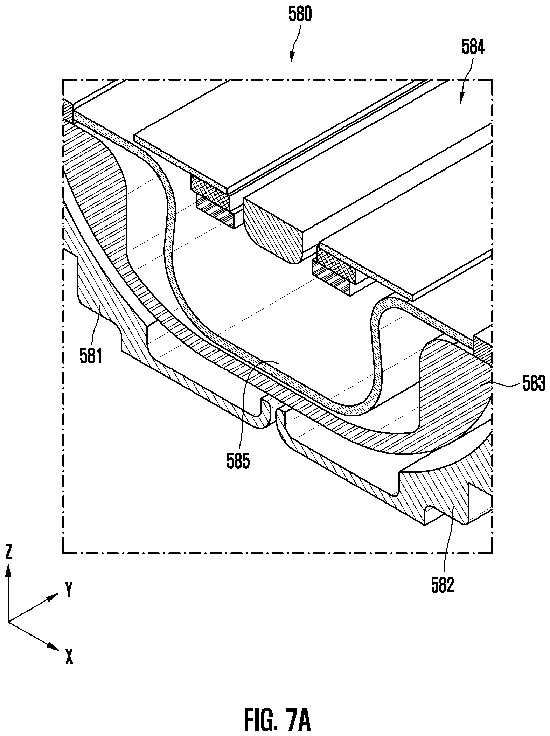

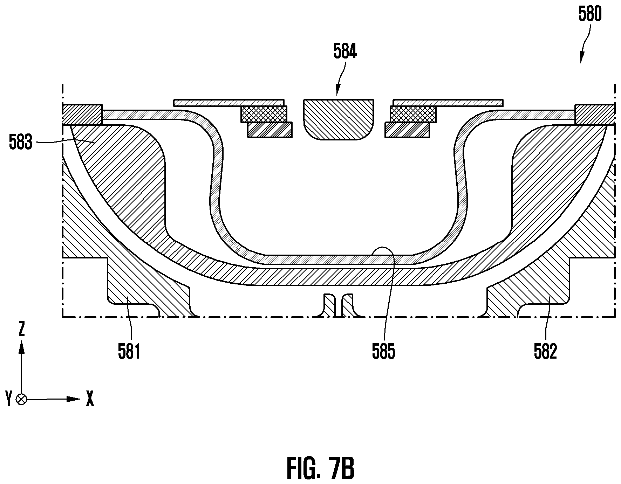

According to various embodiments, the base film layer 310 is a flexible base substrate including an insulating polymer, and may be, for example, polyimide (PI), polycarbonate (PC), polypropylene (PP), polyethylene terephthalate (PET), or polymethyl methacrylate (PMMA), but is not limited thereto. According to various embodiments, a thickness of the base film layer 310 is about 7.5 µm to about 25 µm; about 7.5 µm to about 20 µm; about 7.5 µm to about 15 µm; about 7.5 µm to about 12 µm; about 7.5 µm to about 10 µm; about 8 µm to about 20 µm; about 9 µm to about 20 µm; about 11 µm to about 20 µm; about 13 µm to about 20 µm; about 16 µm to about 20 µm; or about 18 µm to about 20 µm, thereby supporting a metal thin film layer and provide bendability when applied to a hinge portion (e.g., the hinge structure 230 of the electronic device 200 of FIG. 3, or between a hinge housing 583 and a hinge assembly 584 of an electronic device 580 of FIGS. 7A and 7B).

According to various embodiments, a conductive pattern may be further formed on at least a portion of at least one of the metal thin film layers 320 and 330, and this may be formed by patterning the metal thin film layers 320 and 330 or forming a conductive pattern layer on the metal thin film layers 320 and 330. For example, the conductive pattern may form a pattern (e.g., an internal circuit pattern) by patterning a copper foil of a flexible copper clad laminate (FCCL). For example, the conductive pattern layer (e.g., an internal circuit pattern) may be formed by performing printing with a material containing a conductive metal (e.g., copper or a copper alloy) component used in the field of PCB.

According to various embodiments, an adhesive layer (not shown) may be further included between the metal thin film layers 320 and 330 and the base film layer 310, and the adhesive layer may be an insulating material. According to various embodiments, the metal thin film layers 320 and 330 may be a single layer or a plurality of layers. According to various embodiments, a thickness of each of the metal thin film layers 320 and 330 may be about 6 µm to about 36 µm; about 6 µm to about 34 µm; about 6 µm to about 32 µm; about 6 µm to about 30 µm; about 6 µm to about 28 µm; about 6 µm to about 25 µm; about 6 µm to about 10 µm; about 6 µm to about 8 µm; about 7 µm to about 36 µm; about 9 µm to about 36 µm; about 12 µm to about 36 µm; about 15 µm to about 36 µm; about 18 µm to about 36 µm; about 20 µm to about 36 µm; or about 25 µm to about 36 µm.

According to various embodiments, surfaces of the metal thin film layers 320 and 330 may include two or more areas having different surface characteristics. For example, the surfaces thereof may include two or more areas with different surface roughness. This may improve adhesion and bendability when applied to a part requiring bendability (e.g., an RFPCB) or a hinge portion of an electronic device (e.g., the hinge structure 230 of the electronic device 200 of FIG. 3, or between the hinge housing 583 and the hinge assembly 584 of the electronic device 580 of FIGS. 7A and 7B). For example, it is possible to improve the bending life and bendability in a repeated bending area of a hinge portion having a bending structure, and provide an RFPCB with improved adhesion between components.

According to various embodiments, each of two or more areas having different surface characteristics (e.g., surface roughness) of the metal thin film layers 320 and 330 may be formed in a single area or a plurality of areas (e.g., 322, 332, 321a, 321b, 331a, and 331b of FIG. 5). The plurality of areas (e.g., 322, 332, 321a, 321b, 331a, and 331b of FIG. 5) may be distinguished by surface treatment methods.

According to various embodiments, the metal thin film layers 320 and 330 may include two or more areas (e.g., 322, 332, 321a, 321b, 331a, and 331b of FIG. 5) having different surface roughness formed by surface treatment using different surface treatment processes. For example, the surface treatment process may be selected from a soft etching process and an oxide surface treatment process, the surface of the metal thin film layers 320 and 330 may be etched by the surface treatment process to form surface roughness, and a degree of the surface roughness (e.g., an average value of surface roughness or an etching depth) may be controlled depending on the etching amount.

According to various embodiments, a portion of the surface of the metal thin film layers 320 and 330 may be surface-treated by a soft etching process, and a wet etching, flash etching, or quick etching method may be used for the soft etching process. In some examples, in the wet etching, a soft etchant containing an inorganic acid or an organic acid may be used. For example, the soft etching process may be performed using a soft etching solution such as a persulfate/sulfuric acid type (e.g., H₂O₂ and H₂SO₄), a sodium persulfate/sulfuric acid type (e.g., Na₂S₂O₈ and H₂SO₄), but is not limited thereto. According to various embodiments, the surface of the metal thin film layers 320 and 330, other than the area surface-treated by the soft etching process, may be optionally oxide-treated, and the oxide surface treatment may be a brown oxide process or a black oxide process. In some examples, a brown oxide reactant may be used, for example, the brown oxide reactant may include peroxide (H₂O₂). In some examples, a black oxide reactant may be used, for example, the black oxide reactant may contain an oxidizing agent and a base, the oxidizing agent may contain NaClO, NaClO₂, NaClO₃, KClO, KClO₂, and KClO₃, and the base may contain, as a hydroxide compound, sodium hydroxide, potassium hydroxide, barium hydroxide, ammonium hydroxide, tetramethylammonium hydroxide, or tetraethylammonium hydroxide, but are not limited thereto.

According to various embodiments, the surface roughness of the soft etching-treated area and the oxide surface-treated area may be different from each other. For example, the soft etching-treated area may have lower etching amount than the oxide surface-treated area, resulting in lower surface roughness, which may improve bendability. The oxide surface-treated area may form a large surface roughness to improve adhesion.

According to various embodiments, referring to FIG. 5, the metal thin film layers 320 and 330 may include a first metal thin film layer 320 formed on one surface of the base film layer 310, and a second metal thin film layer 330 formed on the opposite surface. The surfaces of the first metal thin film layer 320 and the second metal thin film layer 330 may include two or more areas with different surface characteristics (e.g., surface roughness) depending on the surface treatment methods. For example, the surfaces thereof may include first oxide surface-treated areas 321a and 331a and second oxide surface-treated areas 321b and 331b, and soft etching-treated areas 322 and 332 may be included between the first oxide surface-treated areas 321a and 331a and the second oxide surface-treated areas 321b and 331b. According to various embodiments, the soft etching-treated areas 322 and 332 and the oxide surface-treated areas 321a, 321b, 331a, and 331b may have different surface roughness. According to various embodiments, the soft etching-treated areas 322 and 332 may include two or more areas having the same or different surface characteristics (e.g., surface roughness). In some examples, the area 322 and the area 332 may have the same or different surface characteristics.

According to various embodiments, the oxide surface-treated areas 321a, 321b, 331a, and 331b may include two or more areas having the same or different surface characteristics (e.g., surface roughness). In some examples, the area 321a, the area 321b, the area 331a, and the area 331b may have the same or different surface characteristics.

According to various embodiments, the surface roughness of the soft etching-treated areas 322 and 332 may be lower than the surface roughness of the oxide surface-treated areas 321a, 321b, 331a, and 331b.

According to various embodiments, the metal thin film layers 320 and 330 may contain at least one metal or an alloy of Cu, Ag, Cr, Fe, In, Ni, P, Si, Sn, Te, Ti, Zn, and Zr. In some examples, the metal thin film layers 320 and 330 may contain a copper foil or a copper alloy foil. For example, the copper alloy foil 320 and 330 may contain Cu; and at least one or more of Ag, Cr, Fe, In, Ni, P, Si, Sn, Te, Ti, Zn, and Zr or a mixture thereof (e.g., 0.01 mass % to 1 mass % of the alloy).

FIG. 6 is a cross-sectional view of an RFPCB according to various embodiments. According to various embodiments, FIG. 6 illustrates a cross-sectional view of an RFPCB 400 to be applied to a hinge portion of an electronic device (e.g., the hinge structure 230 of the electronic device 200 of FIG. 3, or between the hinge housing 583 and the hinge assembly 584 of the electronic device 580 of FIGS. 7A and 7B).

Referring to FIG. 6, according to various embodiments, the RFPCB 400 may include a composite film layer 410, and rigid areas R and R' and a flexible area F formed on the composite film layer 410.

According to various embodiments, the composite film layer 410 (e.g., the composite film 300 of FIG. 5) may include a base film layer 411, and metal thin film layers 412 and 413 on both surfaces of the base film layer 411.

According to various embodiments, the base film layer 411 is a flexible base substrate including an insulating polymer, and may be, for example, PI, PC, PP, PET, or PMMA, but is not limited thereto. According to various embodiments, the thickness of the base film layer 310 may be about 7.5 µm to about 25 µm; about 7.5 µm to about 20 µm; about 7.5 µm to about 15 µm; about 7.5 µm to about 12 µm; about 7.5 µm to about 10 µm; about 8 µm to about 25 µm; about 9 µm to about 25 µm; about 10 µm to about 25 µm; about 13 µm to about 25 µm; about 16 µm to about 25 µm; or about 18 µm to about 25 µm. It is possible to support a metal thin film layers and provide bendability when applied to a hinge portion (e.g., the hinge structure 230 of the electronic device 200 of FIG. 3, or between the hinge housing 583 and the hinge assembly 584 of the electronic device 580 of FIGS. 7A and 7B).

According to various embodiments, a conductive pattern may be further formed on at least a portion of at least one of the metal thin film layers 412 and 413, and this may be formed by patterning the metal thin film layers 412 and 413 or forming a conductive pattern layer on the metal thin film layers 412 and 413. For example, the conductive pattern may form a pattern (e.g., an internal circuit pattern) by patterning a copper foil of a FCCL. For example, the conductive pattern layer (e.g., an internal circuit pattern) may be formed by performing printing with a material containing a conductive metal (e.g., copper or a copper alloy) component used in the field of PCB.

According to various embodiments, an adhesive layer (not shown) may be further included between the metal thin film layers 412 and 413 and the base film layer 411, and the adhesive layer may be an insulating material.

According to various embodiments, each of the metal thin film layers 412 and 413 may be a single layer or a plurality of layers. According to various embodiments, each thickness of the metal thin film layers 412 and 413 may be about 6 µm to about 36 µm; about 6 µm to about 34 µm; about 6 µm to about 32 µm; about 6 µm to about 30 µm; about 6 µm to about 28 µm; about 6 µm to about 25 µm; about 6 µm to about 10 µm; about 6 µm to about 8 µm; about 7 µm to about 36 µm; about 9 µm to about 36 µm; about 12 µm to about 36 µm; about 15 µm to about 36 µm; about 18 µm to about 36 µm; about 20 µm to about 36 µm; or about 25 µm to about 36 µm.

According to various embodiments, surfaces of the metal thin film layers 412 and 413 may include two or more areas having different surface characteristics, and, for example, the surfaces thereof may include two or more areas with different surface roughness. This may improve adhesion and bendability when applied to a part requiring bendability (e.g., an RFPCB) or a hinge portion of an electronic device (e.g., the hinge structure 230 of the electronic device 200 of FIG. 3, or between the hinge housing 583 and the hinge assembly 584 of the electronic device 580 of FIGS. 7A and 7B). For example, it is possible to improve the bending life and bendability in a repeated bending area of a hinge portion having a bending structure, and provide an RFPCB with improved adhesion between components.

According to various embodiments, each of two or more areas having different surface characteristics (e.g., surface roughness) of the metal thin film layers 412 and 413 may be formed in a single area or a plurality of areas (e.g., 422, 432, 421a, 421b, 431a, and 431b of FIG. 6). The plurality of areas (e.g., 422, 432, 421a, 421b, 431a, and 431b of FIG. 6) may be distinguished by surface treatment methods, but may have different surface roughness.

According to various embodiments, the metal thin film layers 412 and 413 may include two or more areas (e.g., 422, 432, 421a, 421b, 431a, and 431b of FIG. 6) having different surface roughness formed by surface treatment with different surface treatment processes. For example, the surface treatment process may be selected from a soft etching process and an oxide surface treatment process, the surface of the metal thin film layers 412 and 413 may be etched by the surface treatment process to form surface roughness, and a degree of the surface roughness (e.g., an average value of surface roughness or an etching depth) may be controlled depending on the etching amount.

According to various embodiments, a portion of the surface of the metal thin film layers 412 and 413 may be surface-treated by a soft etching process, and a wet etching, flash etching, or quick etching method may be used for the soft etching process. In some examples, in the wet etching, a soft etchant containing an inorganic acid or an organic acid may be used. For example, the soft etching process may be performed using a soft etching solution such as a persulfate/sulfuric acid type (e.g., H₂O₂ and H₂SO₄), a sodium persulfate/sulfuric acid type (e.g., Na₂S₂O₈ and H₂SO₄), but is not limited thereto. According to various embodiments, the surface of the metal thin film layers 412 and 413, other than the area surface-treated by the soft etching process, may be optionally oxide-treated, and the oxide surface treatment may be a brown oxide process or a black oxide process. In some examples, a brown oxide reactant may be used, for example, the brown oxide reactant may include peroxide (H₂O₂). In some examples, a black oxide reactant may be used, for example, the black oxide reactant may contain an oxidizing agent and a base, the oxidizing agent may contain NaClO, NaClO₂, NaClO₃, KClO, KClO₂, and KClO₃, and the base may contain, as a hydroxide compound, sodium hydroxide, potassium hydroxide, barium hydroxide, ammonium hydroxide, tetramethylammonium hydroxide, or tetraethylammonium hydroxide, but are not limited thereto.

According to various embodiments, the surface roughness of the soft etching-treated area and the oxide surface-treated area may be different from each other. For example, the soft etching-treated area may have lower etching amount than the oxide surface-treated area, resulting in lower surface roughness, which may improve bendability. The oxide surface-treated area may form a large surface roughness to improve adhesion.

According to various embodiments, referring to FIG. 6, the metal thin film layers 412 and 413 may include a first metal thin film layer 412 formed on one surface of the base film layer 411, and a second metal thin film layer 413 formed on the opposite surface. The surfaces of the first metal thin film layer 412 and the second metal thin film layer 413 may include two or more areas with different surface characteristics (e.g., surface roughness) depending on the surface treatment methods. For example, the surfaces thereof may include first oxide surface-treated areas 421a and 431a and second oxide surface-treated areas 421b and 431b, and soft etching-treated areas 422 and 432 may be included between the first oxide surface-treated areas 421a and 431a and the second oxide surface-treated areas 421b and 431b. According to various embodiments, the soft etching-treated areas 422 and 432 and the oxide surface-treated areas 421a, 421b, 431a, and 431b may have different surface roughness.

According to various embodiments, the surface roughness of the soft etching-treated areas 422 and 432 may be lower than the surface roughness of the oxide surface-treated areas 421a, 421b, 431a, and 431b.

According to various embodiments, the first oxide surface-treated areas 421a and 431a and the second oxide surface-treated areas 421b and 431b may improve the adhesion between the components of the rigid areas R and R' (e.g., an insulating layer 441 and the composite film layer 410 (e.g., the metal thin film layers 412 and 413) of FIG. 6), and the soft etching-treated areas 422 and 432 may improve the adhesion and improve the repeated bending life between the components of the flexible area F (e.g., a coverlay adhesive layer 451 and the composite film layer (e.g., the metal thin film layers 412 and 413) of FIG. 6). For example, the soft etching-treated areas 422 and 432 may have low surface roughness due to a lower etching amount compared to the first oxide surface-treated areas 421a and 431a and the second oxide surface-treated areas 421b and 431b, and thus, the degree of a notch is lower, which may improve the repeated bending life. For example, a flow may occur in the soft etching-treated areas 422 and 432 (e.g., at a boundary or near the rigid areas R and R' and the flexible area F) to reduce occurrence of cracks.

According to various embodiments, the metal thin film layers 412 and 413 may contain at least one metal or an alloy of Cu, Ag, Cr, Fe, In, Ni, P, Si, Sn, Te, Ti, Zn, and Zr. In some examples, the metal thin film layers 412 and 413 may each include a copper foil or a copper alloy foil. For example, the copper alloy foil may contain Cu; and at least one or more of Ag, Cr, Fe, In, Ni, P, Si, Sn, Te, Ti, Zn, and Zr or a mixture thereof (e.g., 0.01 mass % to 1 mass % of the alloy). According to various embodiments, each thickness of the metal thin film layers 412 and 413 may be about 6 µm to about 36 µm; about 6 µm to about 34 µm; about 6 µm to about 32 µm; about 6 µm to about 30 µm; about 6 µm to about 28 µm; about 6 µm to about 25 µm; about 6 µm to about 10 µm; about 6 µm to about 8 µm; about 7 µm to about 36 µm; about 9 µm to about 36 µm; about 12 µm to about 36 µm; about 15 µm to about 36 µm; about 18 µm to about 36 µm; about 20 µm to about 36 µm; or about 25 µm to about 36 µm.

According to various embodiments, the rigid areas R and R' may be formed on at least a portion of at least one surface of the composite film 410, and in some examples, may be formed on at least a portion on both surfaces (e.g., the metal thin film layers 412 and 413) of the composite film 410. In some examples, the rigid area R may be formed on the oxide surface-treated area of the metal thin film layers 412 and 413, in order to improve the adhesion between the surfaces of the metal thin film layers 412 and 413 and the component (e.g., the insulating layer 441) on a lower end of the rigid area R and reduce the occurrence of via cracks. For example, the rigid areas R and R' may be formed on the first oxide surface-treated areas 421a and 431a and the second oxide surface-treated areas 421b and 431b.

According to various embodiments, each of the rigid areas R and R' may include a laminated structure 440 including an insulating layer 441, a pattern layer 442, and a photo solder resist (PSR) layer 444. The rigid areas R and R' may be rigid portions having rigidity that are less flexible or less likely to be bent than the flexible area F.

According to various embodiments, the insulating layer 441 may be formed on the oxide surface-treated areas 421a, 431a, 421b, and 431b and may include a thermosetting resin or a prepreg (PPG). For example, the PPG may be a material in which a liquid synthetic resin is impregnated into a fiber reinforcing agent (e.g., a reinforcing base material), such as carbon fiber or glass fiber. The PPG may include, for example, thermosetting resins such as phenol resins or epoxy resins, and thermoplastic resins such as polyether ketone. The PPG may include, for example, a unidirectional PPG and a cross PPG. In some examples, the PPG may include a low-flow type PPG or a flowable semi-cured state (B stage) PPG, and may be cured through a pressurization and heating process in a semi-cured state.

According to various embodiments, the pattern layer 442 is formed with a via 443 and a conductor pattern layer, and the via 443 may be formed in the insulating layer 441 through laser drilling, etc., and electroplating may be performed by forming an electroless plating layer 442 on an inner wall surface of the via 443, and/or forming a plating resist pattern on the insulating layer 441 to form the pattern layer 442. The PSR layer 444 may be a protective layer for protecting components (e.g., pattern layer 442) of the rigid areas R and R'.

According to various embodiments, the rigid areas R and R' may be formed in a single area or a plurality of areas. In some examples, the first rigid area R and the second rigid area R' may be included, and the flexible area F may be positioned between the first rigid area R and the second rigid area R'. In some examples, the first rigid area R, the flexible area F, the second rigid area R', and the flexible area F may be arranged sequentially.

According to various embodiments, the flexible area F may be formed on at least a portion of at least one surface of the composite film 410, and in some examples, may be formed on at least a portion of both surfaces (e.g., the metal thin film layers 412 and 413) of the composite film 410. In some examples, the flexible area F may be formed on the soft etching-treated areas 422 and 432 with a smaller etching amount than the oxide surface-treated area of the metal thin film layers 412 and 413, in order to improve not only the adhesion between the surface of the metal thin film layers 412 and 413 and the component (e.g., the coverlay adhesive layer 451) at the lower end of the flexible area F but also the bendability. This may stably improve the repeated bending life of a hinge portion having a repeated bending structure (e.g., the hinge structure 230 of the electronic device 200 of FIG. 3, or between the hinge housing 583 and the hinge assembly 584 of the electronic device 580 of FIGS. 7A and 7B).

According to various embodiments, the flexible area F may include a laminated structure 450 including the coverlay adhesive layer 451 and a coverlay layer 452. The coverlay adhesive layer 451 may be formed on the soft etching-treated areas 422 and 432, and the coverlay layer 452 may be formed on the coverlay adhesive layer 451. The coverlay layer 452 may be a protective layer that prevents damage to the metal thin film layers 412 and 413 due to corrosion or external impact, and the coverlay layer 452 may include a coverlay film (e.g., a PI film) that contains the same components as the base film layer 411, and may be fixed by the coverlay adhesive layer 451.

According to various embodiments, some components of the flexible area F may extend to a portion of the rigid areas R and R'. For example, a portion (e.g., a terminal area) of the adhesive layer 451 and the coverlay layer 452 of the flexible F may extend to a portion of the rigid areas R and R'. For example, a portion (e.g., a terminal area) of the adhesive layer 451 and the coverlay layer 452 of the flexible F may extend to a portion of the rigid areas R and R', and the extended portion may be disposed to contact or be spaced apart from some components (e.g., the electroless plating layer 442) of the first rigid area R and the second rigid area R'.

According to various embodiments, the thickness of each of the coverlay adhesive layer 451 and the coverlay layer 452 may be about 7.5 µm to 30 µm; about 7.5 µm to about 25 µm; about 7.5 µm to about 20 µm; about 7.5 µm to about 15 µm; about 7.5 µm to about 12 µm; about 7.5 µm to about 10 µm; about 8 µm to about 30 µm; about 10 µm to about 30 µm; about 13 µm to about 30 µm; about 16 µm to about 30 µm; about 18 µm to about 30 µm; or about 20 µm to about 30 µm. In some examples, the thickness of the coverlay adhesive layer 451 may be about 10 µm to 30 µm, and the thickness of the coverlay layer 452 may be about 7.5 µm to 25 µm. For example, the thickness of the coverlay adhesive layer 451 and the coverlay layer 452 may be applied to improve the protective function and flexibility.

FIG. 7A is a perspective view illustrating a state where an RFPCB is disposed between a hinge housing and a hinge assembly of a foldable electronic device according to various embodiments.

FIG. 7B is a cross-sectional view schematically illustrating a state where an RFPCB is disposed between a hinge housing and a hinge assembly of a foldable electronic device according to various embodiments.

Referring to FIGS. 7A and 7B, according to various embodiments, a foldable electronic device 580 (e.g., the electronic device 200 of FIGS. 2 to 4A and 4B) may include a composite film (e.g., the composite film 300 of FIG. 5) or an RFPCB (e.g., the RFPCB 400 of FIG. 6). The foldable electronic device 580 (e.g., the electronic device 200 of FIGS. 2 to 4A and 4B) may include a foldable display (e.g., the foldable display 250 of FIGS. 2 to 4A and 4B).

According to various embodiments, the foldable electronic device 580 (e.g., the electronic device 200 of FIGS. 2 to 4A and 4B) may include a first component, a second component, and a composite film (e.g., the composite film 300 of FIG. 5) or an RFPCB (e.g., the RFPCB 400 of FIG. 6) electrically connecting the first component and the second component.

According to various embodiments, the foldable electronic device 580 (e.g., the electronic device 200 of FIGS. 2 to 4A and 4B) may include a first housing 581 (e.g., the first housing structure 210 of FIGS. 2 to 4A and 4B), a second housing 582 (e.g., the second housing structure 220 of FIGS. 2 to 4A and 4B), a hinge housing 583, a hinge assembly 584, and an RFPCB 585. According to various embodiments, the RFPCB 585 may include the composite film 300 of FIG. 5 or the RFPCB 400 of FIG. 6.

According to various embodiments, the hinge assembly 584 may connect the first and second housings 581 and 582 to be foldable and unfoldable, and the RFPCB 585 (e.g., including the composite film 300 of FIG. 5 or the RFPCB 400 of FIG. 6) may be a connecting device for electrically connecting the first component disposed in the first housing 581 and the second component disposed in the second housing 582. According to various embodiments, during the folding and unfolding operation of the foldable electronic device 580, the RFPCB 585 may transmit signals between the first and second components and may be accommodated in the hinge housing 583.

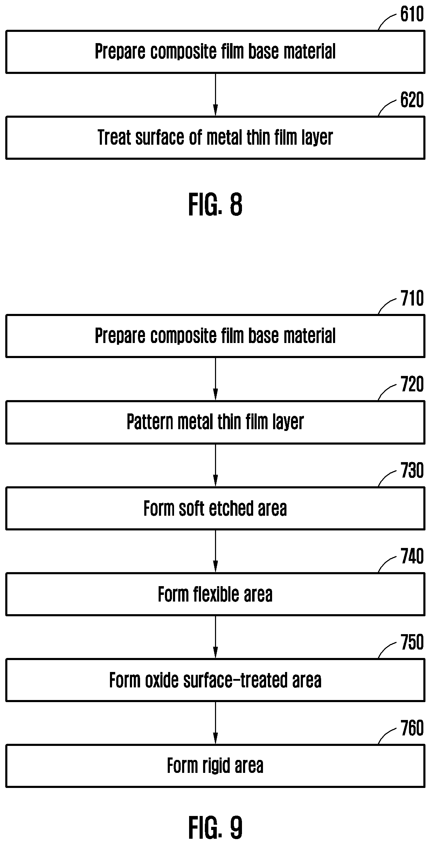

FIG. 8 is a flowchart of an operation of manufacturing a composite film according to various embodiments.

Referring to FIG. 8, according to various embodiments, a method of manufacturing a composite film (e.g., the composite film 300 of FIG. 5) may include operation 610 of preparing a composite film base material having a base material and a metal thin film layer formed on the base material; and operation 620 of treating a surface of the metal thin film layer.

According to various embodiments, in operation 610 of preparing the composite film base material, the composite film base material may include a base film layer (e.g., the base film layer 310 of FIG. 5) and a metal thin film layer (e.g., the metal thin film layers 320 and 330 of FIG. 5) formed at least partially on both surfaces of the base film layer (e.g., the base film layer 310 of FIG. 5). In some examples, the composite film base material may be an FCCL.

According to various embodiments, operation 620 of treating the surface of the metal thin film layer includes forming an area having two or more surface characteristics through the surface treatment, and for example, a soft etching process and an oxide treatment process may be used. A wet etching, flash etching, or quick etching method may be used for the soft etching process. According to various embodiments, in the wet etching, a soft etchant containing an inorganic acid or an organic acid may be used. For example, the soft etching process may be performed using a soft etching solution such as a persulfate/sulfuric acid type (e.g., H₂O₂ and H₂SO₄), a sodium persulfate/sulfuric acid type (e.g., Na₂S₂O₈ and H₂SO₄), but is not limited thereto. According to various embodiments, the surface of the metal thin film layers 320 and 330, other than the area surface-treated by the soft etching process, may be optionally oxide-treated, and the oxide surface treatment may be performed using a brown oxide reactant or a black oxide reactant. In some examples, a brown oxide reactant may be used, for example, the brown oxide reactant may include peroxide (H₂O₂). In some examples, a black oxide reactant may be used, for example, the black oxide reactant may contain an oxidizing agent and a base, the oxidizing agent may contain NaClO, NaClO₂, NaClO₃, KClO, KClO₂, and KClO₃, and the base may contain, as a hydroxide compound, sodium hydroxide, potassium hydroxide, barium hydroxide, ammonium hydroxide, tetramethylammonium hydroxide, or tetraethylammonium hydroxide, but are not limited thereto.

According to various embodiments, the method may further include an operation of patterning the metal thin film layer of the composite film base material or an operation of forming a pattern layer on the metal thin film layer of the composite film base material. This may be performed before and/or after operation 620 of treating the surface of the metal thin film layer. In some examples, this may be performed before operation 620 of treating the surface of the metal thin film layer, and the characteristics of the pattern surface (e.g., the surface roughness) may be controlled through the surface treatment.

FIG. 9 is a flowchart of an operation of manufacturing an RFPCB according to various embodiments.

Referring to FIG. 9, according to various embodiments, a method of manufacturing an RFPCB (e.g., the RFPCB 400 of FIG. 6) may include operation 710 of preparing a composite film base material; operation 720 of patterning a metal thin film layer; operation 730 of forming a soft etched area on at least a portion of the patterned metal thin film layer; operation 740 of forming a flexible area in the soft etched area; operation 750 of forming an oxide surface-treated area on at least a portion of the metal thin film layer; and operation 760 of forming a rigid area in the oxide surface-treated area.

According to various embodiments, operation 710 of preparing the composite film base material may be the same as or similar to operation 610 of preparing the composite film base material described above with reference to the flowchart of the composite film of FIG. 8.

According to various embodiments, in operation 720 of patterning the metal thin film layer, a patterning process of a metal thin film known in the technical field of the present disclosure may be used, and is not specifically described herein.

According to various embodiments, operation 730 of forming the soft etched area and operation 750 of forming the oxide surface-treated area may be the same as or similar to the soft etching process and the oxide surface treatment process described above with reference to the flowchart of the composite film of FIG. 8, respectively.

According to various embodiments, operation 740 of forming the flexible area may include laminating and rolling an adhesive layer (e.g., the coverlay adhesive layer 451 of FIG. 6) and a coverlay layer (e.g., the coverlay layer 452 of FIG. 6) on the surface of the metal thin film layer.

According to various embodiments, operation 760 of forming the rigid area may include an operation of forming an insulating layer (e.g., the insulating layer 441 of FIG. 6) by a coating process; an operation of forming a via (e.g., the via 443 of FIG. 6) in the insulating layer (e.g., the insulating layer 441 of FIG. 6); an operation of forming a conductor pattern (e.g., the pattern layer 442 of FIG. 6) on the insulating layer; and an operation of forming a protective layer (e.g., the protective layer 444 of FIG. 6). Each operation may be performed using methods such as coating, printing, drilling, patterning, etching, and plating (e.g., electroless plating), which are not specifically described herein.

According to various embodiments, the bending horizontality of an RFPCB (e.g., the RFPCB 400 of FIG. 6) was evaluated. For example, a sample 1 is obtained by an oxide surface treatment (e.g., a brown oxide treatment) over the entire surface, and a sample 2 is obtained by an oxide surface treatment (e.g., a brown oxide treatment) and a soft etching treatment. The sample 1 and the sample 2 each include an FCCL having a base PI film and a copper foil of about 12 µm. RFPCBs (e.g., the RFPCB 400 of FIG. 6) were manufactured using each of the sample 1 and the sample 2. [Table 1] below shows the results of the bending life evaluation of the RFPCBs to which the FCCLs of the sample 1 and the sample 2 were applied. Referring to [Table 1], it may be confirmed that the RFPCB (a sample 2-1) according to the embodiment of the present disclosure has a bending life increased by about 2 times or more compared to the PCB (a sample 1-1) according to a comparative example in which the entire surface is oxide-treated during heterogeneous pretreatment of an inner layer copper foil.

**[Table 1]**

| RFPCB | Sample 1-1 | Sample 2-1 |
|---|---|---|
| FCCL | Sample 1 | Sample 2 |
| Surface pretreatment | Oxide surface pretreatment | Soft etching/oxide surface pretreatment |
| Repeated number of times of bending life | 4094 | 8018 |

| | | |
|---|---|---|
| *Process conditions for evaluating the bending life: ±90 degrees (°) and performed 30,000 times (0.38 R, load of 300 G, 60 times/min) | | |

According to various embodiments, a composite film (300) may include a base film layer (310); a first metal thin film layer (320) formed on one surface of the base film layer (310); and a second metal thin film layer (330) formed on an opposite surface. The first metal thin film layer (320) and the second metal thin film layer (330) may include a soft etching-treated area (322, 332) and an oxide surface-treated area (321a, 321b, 331a, 331b), and the soft etching-treated area (322, 332) and the oxide surface-treated area (321a, 321b, 331a, 331b) may have different surface roughness.

According to various embodiments, the surface roughness of the soft etching-treated area (322, 332) may be lower than the surface roughness of the oxide surface-treated area (321a, 321b, 331a, 331b).

According to various embodiments, the oxide surface-treated area (321a, 321b, 331a, 331b) may be formed by a brown oxide operation or a black oxide operation.

According to various embodiments, the soft etching-treated area (322, 332) may be formed by wet etching, flash etching, or quick etching operation.

According to various embodiments, the first metal thin film layer (320) and the second metal thin film layer (330) may each include a copper foil or a copper alloy foil.

According to various embodiments, the base film layer (310) may have a thickness of about 7.5 µm to about 25 µm, and the first metal thin film layer (320) and the second metal thin film layer (330) may have thicknesses of about 6 µm to about 36 µm, respectively.

According to various embodiments, a first oxide surface-treated area (321a, 331a) and a second oxide surface-treated area (321b, 331b) may be included, and the soft etching-treated area (322, 332) may be included between the first oxide surface-treated area (321a, 331a) and the second oxide surface-treated area (321b, 331b).

According to various embodiments, an RFPCB may include a composite film (410); a flexible area (F) formed on at least a portion of at least one surface of the composite film (410); and a rigid area (R, R') formed on at least a portion of the at least one surface of the composite film (410). The composite film (410) may include a base film layer (411); and a first metal thin film layer (412) formed on one surface of the base film layer (411); and a second metal thin film layer (413) formed on an opposite surface, the first metal thin film layer (412) and the second metal thin film layer (413) may include a soft etching-treated area (422, 432) and an oxide surface-treated area, and the soft etching-treated area (422, 432) and the oxide surface-treated area (421a, 431a, 421b, 431b) may have different surface roughness.

According to various embodiments, the flexible area (F) may be formed on the soft etching-treated area (422, 432), and the rigid area (R, R') may be formed on the oxide surface-treated area (421a, 431a, 421b, 431b).

According to various embodiments, a portion of a component formed on the flexible area (F) may extend to a portion of the rigid area (R, R').

According to various embodiments, the flexible area (F) may include a coverlay adhesive layer (451) formed on the soft etching-treated area (422, 432); and a coverlay layer (452) formed on the coverlay adhesive layer (451).

According to various embodiments, the coverlay adhesive layer (451), the coverlay layer (452), or portion of the coverlay adhesive layer and coverlay layer may extend to a portion of the rigid area (R, R').

According to various embodiments, the coverlay layer (452) and the coverlay adhesive layer (451) may have thicknesses of about 7.5 µm to about 30 µm, respectively.

According to various embodiments, the surface roughness of the soft etching-treated area (422, 432) may be lower than the surface roughness of the oxide surface-treated area (421a, 431a, 421b, 431b).

According to various embodiments, the oxide surface-treated area (421a, 431a, 421b, 431b) may be formed by a brown oxide operation or a black oxide operation.

According to various embodiments, the soft etching-treated area (422, 432) may be formed by wet etching, flash etching, or quick etching operation.

According to various embodiments, a circuit pattern may be formed on the first metal thin film layer (412) and the second metal thin film layer (413).

According to various embodiments, the electronic device may include a flexible display; and the composite film (300) of the present disclosure or the RFPCB (400) of the present disclosure.

According to various embodiments, the composite film (300) or the RFPCB (400) may be applied to a hinge portion of the electronic device.

According to various embodiments, the electronic device may include a foldable display.

The electronic device according to various embodiments may be one of various types of electronic devices. The electronic device may include, for example, a portable communication device (e.g., a smartphone), a computer device, a portable multimedia device, a portable medical device, a camera, a wearable device, or a home appliance device. According to an embodiment of the disclosure, the electronic device is not limited to those described above.

It should be appreciated that various embodiments of the present disclosure and the terms used therein are not intended to limit the technological features set forth herein to particular embodiments and include various changes, equivalents, or replacements for a corresponding embodiment. In connection with the description of the drawings, like reference numerals may be used for similar or related components. It is to be understood that a singular form of a noun corresponding to an item may include one or more of the things, unless the relevant context clearly indicates otherwise. As used herein, "A or B," "at least one of A and B," "at least one of A or B," "A, B or C," "at least one of A, B and C," and "at least one of A, B, or C," each of which may include any one of the items listed together in the corresponding one of the phrases, or all possible combinations thereof. Terms such as "1st", "2nd", or "first" or "second" may simply be used to distinguish the component from other components in question, and do not limit the components in other aspects (e.g., importance or order). It is to be understood that if a component (e.g., a first component) is referred to, with or without the term "operatively" or "communicatively", as "coupled with," "coupled to," "connected with," or "connected to" another component (e.g., a second component), the component may be coupled with the other component directly (e.g., by wire), wirelessly, or via a third component.

As used in connection with embodiments of the disclosure, the term "module" may include a unit implemented in hardware, software, or firmware, and may interchangeably be used with other terms, for example, "logic," "logic block," "part," or "circuitry." A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., the internal memory 136 or the external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read-only memory (CD-ROM)), or be distributed (e.g., downloaded or uploaded) online via an application store (e.g., PlayStore^{™}), or between two user devices (e.g., smartphones) directly. If distributed online, at least portion of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to embodiments, one or more of the above-described components may be omitted, or one or more other components may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to embodiments, operations performed by the module, the program, or another component may be carried out sequentially, in parallel, repeatedly, or heuristically, or one or more of the operations may be executed in a different order or omitted, or one or more other operations may be added.

## Claims

1. A composite film comprising:
a base film layer;
a first metal thin film layer formed on one surface of the base film layer; and
a second metal thin film layer formed on an opposite surface,
wherein the first metal thin film layer and the second metal thin film layer comprise a soft etching-treated area and an oxide surface-treated area, and
the soft etching-treated area and the oxide surface-treated area have different surface roughness.

2. The composite film of claim 1, wherein the surface roughness of the soft etching-treated area is lower than the surface roughness of the oxide surface-treated area.

3. The composite film of one of claims 1 and 2, wherein
the oxide surface-treated area is formed by a brown oxide operation or a black oxide operation, and
the soft etching-treated area is formed by wet etching, flash etching, or quick etching operation.

4. The composite film of one of claims 1 to 3, wherein the first metal thin film layer and the second metal thin film layer each comprise a copper foil or a copper alloy foil.

5. The composite film of one of claims 1 to 4, wherein
the base film layer has a thickness of 7.5 µm to 25 µm, and
the first metal thin film layer and the second metal thin film layer have thicknesses of 6 µm to 36 µm, respectively.

6. The composite film of one of claims 1 to 5, wherein
a first oxide surface-treated area and a second oxide surface-treated area are included, and
the soft etching-treated area is included between the first and second oxide surface-treated areas.

7. A rigid flexible printed circuit board (RFPCB) comprising:
a composite film;
a flexible area formed on at least a portion of at least one surface of the composite film; and
a rigid area formed on at least a portion of the at least one surface of the composite film,
wherein the composite film comprises:
a base film layer; and
a first metal thin film layer formed on one surface of the base film layer; and
a second metal thin film layer formed on an opposite surface,
the first metal thin film layer and the second metal thin film layer comprise a soft etching-treated area and an oxide surface-treated area, and
the soft etching-treated area and the oxide surface-treated area have different surface roughness.

8. The RFPCB of claim 7, wherein
the flexible area is formed on the soft etching-treated area, and
the rigid area is formed on the oxide surface-treated area.

9. The RFPCB of one of claims 7 and 8, wherein a portion of a component formed on the flexible area extends to a portion of the rigid area.

10. The RFPCB of one of claims 7 to 9, wherein
the flexible area comprises:
a coverlay adhesive layer formed on the soft etching-treated area; and
a coverlay layer formed on the coverlay adhesive layer, and
the coverlay adhesive layer, the coverlay layer, or portion of the coverlay adhesive layer and coverlay layer extends to a portion of the rigid area.

11. The RFPCB of one of claims 7 to 10, wherein the coverlay layer and the coverlay adhesive layer have thicknesses of 7.5 µm to 30 µm, respectively.

12. The RFPCB of one of claims 7 to 11, wherein the surface roughness of the soft etching-treated area is lower than the surface roughness of the oxide surface-treated area.

13. The RFPCB of one of claims 7 to 12, wherein
the oxide surface-treated area is formed by a brown oxide operation or a black oxide operation, and
the soft etching-treated area is formed by wet etching, flash etching, or quick etching operation.

14. The RFPCB of one of claims 7 to 13, wherein a circuit pattern is formed on the first metal thin film layer and the second metal thin film layer.

15. An electronic device comprising:
a flexible display; and
the composite film of one of claims 1 to 6 or the rigid flexible printed circuit board (RFPCB) of one of claims 7 to 14.
